**Europäisches Patentamt**

**European Patent Office**

**Office européen des brevets**

(19)

(11) Veröffentlichungsnummer : **0 502 235 B1**

(12)

# EUROPÄISCHE PATENTSCHRIFT

(45) Veröffentlichungstag der Patentschrift :
**24.05.95 Patentblatt 95/21**

(51) Int. Cl.$^6$ : **H03H 17/00**

(21) Anmeldenummer : **91103520.2**

(22) Anmeldetag : **07.03.91**

(54) **Verfahren und Schaltungsanordnung zur nichtlinearen Verknüpfung zweier Binärworte.**

(43) Veröffentlichungstag der Anmeldung :
**09.09.92 Patentblatt 92/37**

(45) Bekanntmachung des Hinweises auf die
Patenterteilung :
**24.05.95 Patentblatt 95/21**

(84) Benannte Vertragsstaaten :
**DE FR GB IT NL SE**

(56) Entgegenhaltungen :
**HEWLETT-PACKARD JOURNAL. Bd. 31, Nr. 1,
Januar 1980,PALO ALTO US Seiten 10 -11; 'A
Digital Attenuator with 1-dB Steps'
PATENT ABSTRACTS OF JAPAN vol. 7, no.
264 (E-212) 24.November 1983 & JP-A-58145
216 ( TOKYO SHIBAURA DENKI ) 30. August
1983**

(73) Patentinhaber : **SIEMENS
AKTIENGESELLSCHAFT
Wittelsbacherplatz 2
D-80333 München (DE)**

(72) Erfinder : **Degenhardt, Achim
Spatzenwinkel 14
W-8000 München 60 (DE)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein Verfahren und eine Schaltungsanordnung zur nichtlinearen Verknüpfung zweier Binärworte.

In vielen Bereichen der digitalen Signalverarbeitung ist es notwendig, zeitdiskrete Signale, die eine Abfolge von Binärworten darstellen, nichtlinear miteinander zu verknüpfen. Insbesondere bei der digitalen Sprachsignalverarbeitung ist es aufgrund des nichtlinearen - annähernd logarithmischen - Verhaltens des menschlichen Ohres sinnvoll, ein Sprachsignal in nichtlinearer - bevorzugt logarithmischer - Abhängigkeit von einem Steuersignal zu bedämpfen, d.h., das Dämpfungsmaß beispielsweise eines Dämpfungsglieds direkt proportional zum Steuersignal einzustellen. Ein Problem stellt dabei die nichtlineare Verknüpfung von Binärworten des Sprachsignals mit Binärworten des Steuersignals dar.

Ein Verfahren und eine Schaltungsanordnung zur nichtlinearen Verknüpfung zweier Binärworte ist aus dem Dokument Hewlett Packard Journal, Januar 1980, Seiten 80-81 bekant.

Aufgabe der Erfindung ist es daher, ein weiteres Verfahren und eine Schaltungsanordnung zur nichtlinearen Verknüpfung zweier Binärworte anzugeben.

Diese Aufgabe wird durch ein Verfahren gemäß Patentanspruch 1 bzw. durch eine Schaltungsanordnung gemäß Patentanspruch 5 gelöst. Ausgestaltungen und Weiterbildungen des Erfindungsgedankens sind Gegenstand von Unteransprüchen.

Vorteil der Erfindung ist der geringe Aufwand bei der Realisierung des Verfahrens bzw. der Schaltungsanordnung.

Die Erfindung wird nachfolgend anhand der in den Figuren der Zeichnung dargestellten Ausführungsbeispiele näher erläutert. Es zeigt:

Figur 1     ein Ausführungsbeispiel einer erfindungsgemäßen Schaltungsanordnung zur Durchführung des erfindungsgemäßen Verfahrens und

Figur 2     ein Anwendungsbeispiel für ein erfindungsgemäßes Verfahren und eine erfindungsgemäße Schaltungsanordnung bei einer Freisprechschaltung.

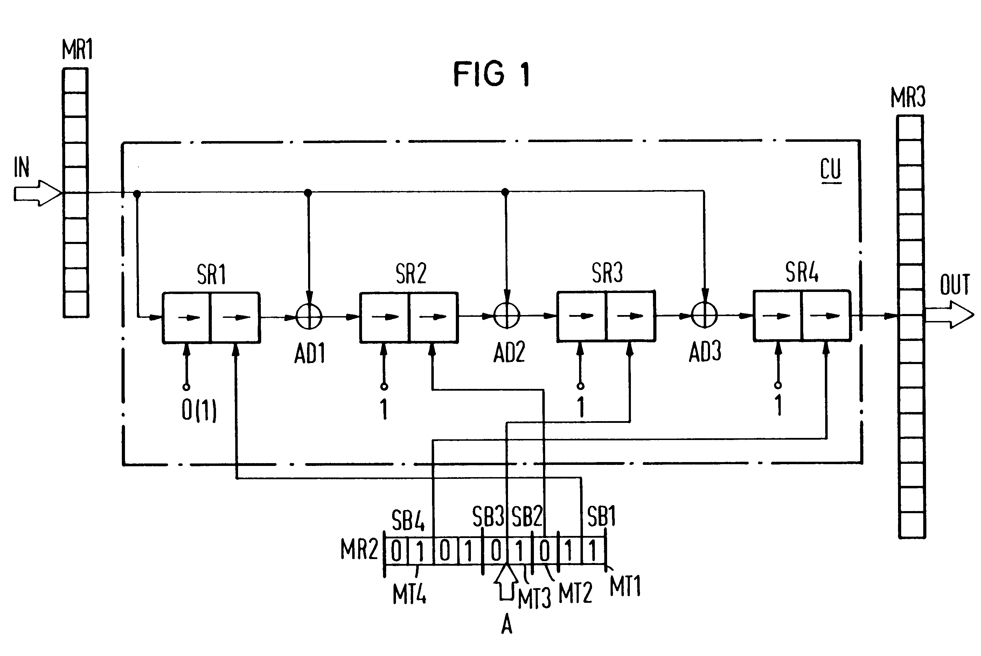

Bei dem Ausführungsbeispiel nach Figur 1 ist eine Recheneinrichtung CU vorgesehen, die vier Schieberegister SR1 bis SR4 aufweist. Mittels der Schieberegister SR2 bis SR4 werden darin eingeschriebene Binärwörter zunächst um eine Stelle und dann um jeweils eine einem zugeordneten Teilbinärwort SB2 bis SB4 entsprechende Anzahl von Stellen rechtsgeschoben. Beim Schieberegister SR1 wird dagegen nur um eine einem zugeordneten Teilbinärwort SB1 entsprechende Anzahl von Stellen rechtsgeschoben. Die Teilbinärworte SB1 bis SB4 sind dabei in vier Teilregister MT1 bis MT4 abgelegt, die zusammen ein Register MR2 bilden. Die Aufteilung des Registers MR2 in vier Teilregister MT1 bis MT4 ist derart, daß die beiden niederwertigsten Bits dem ersten Teilregister MT1, das nächsthöherwertige Bit dem Teilregister MT2, die nächsten beiden höherwertigen Bits dem Teilregister MT3 sowie die vier höherwertigsten Bits dem Teilregister MT4 zugeordnet sind. Das bedeutet, daß das Teilbinärwort SB1 mit niedrigster Wertigkeit innerhalb des Binärwortes A zwei Bit aufweist und daß die Anzahl der Bits bei den übrigen Teilbinärworten SB2, SB3, SB4 mit steigender Wertigkeit innerhalb des Binärwortes A bei 1 beginnend jeweils gleich einer Potenz von 2 ist. Die Teilbinärworte SB1 bis SB4 sind mit zunehmender Wertigkeit innerhalb des Binärwortes A den Stellenzahlen, um die jeweils rechtsgeschoben werden soll, in der Reihenfolge der zugehörigen Verfahrensschritte zugeordnet. Die Teilregister MT1 bis MT4 sind dazu jeweils mit den Steuereingängen der jeweils zugeordneten Schieberegister SR1 bis SR4 verbunden.

Die vier Schieberegister SR1 bis SR4 sind unter Zwischenschaltung von Addierern AD1, AD2, AD3 in Reihe geschaltet. Die Addierer AD1, AD2, AD3 sind zudem, ebenso wie das erste der Schieberegister SR1 mit einem ersten Binärwort IN beaufschlagt, das in einem Register MR1 abgelegt ist. Dabei wird zunächst das Binärwort IN mittels des Schieberegisters SR1 um eine im Teilregister MT1 als Teilbinärwort SB1 abgelegte Stellenzahl rechtsgeschoben und dazu anschließend mittels des Addierers AD1 das Binärwort IN unverändert hinzuaddiert. Alternativ kann ein grundsätzliches Rechtsschieben um eine Stelle auch beim Schieberegister SR1 vorgesehen werden. Für die weiteren Betrachtungen wird allerdings davon ausgegangen, daß darauf verzichtet wird. Das Binärwort am Ausgang des Addierers AD1 wird anschließend im Schieberegister SR2 abgelegt, wo es daraufhin um eine Stelle sowie um eine dem Teilbinärwort SB2 entsprechende Stellenzahl rechtsgeschoben und mittels des Addierers AD2 mit dem Binärwort IN addiert wird. Ein entsprechender Verfahrensschritt wird nachfolgend auch mit dem Schieberegister SR3 und dem Addierer AD3 durchgeführt. Schließlich wird das Binärwort am Ausgang des Addierers AD3 mittels des Schieberegisters SR4 um eine Stelle sowie um eine dem Teilbinärwort SB4 entsprechende Anzahl von Stellen rechtsgeschoben und in ein Register MR3 als Binärwort OUT eingeschrieben, von wo es zur weiteren Verarbeitung ausgelesen werden kann. Während die Binärworte IN und OUT jeweils ein Vorzeichenbit aufweisen, nimmt das Binärwort A nur positive Werte an und besitzt daher kein Vorzeichenbit.

2

EP 0 502 235 B1

Allgemein kann eine erfindungsgemäße Schaltungsanordnung mit n Schieberegistern wie folgt mathematisch beschrieben werden:

$$(1) \qquad Y/X \ = \ 1/2 * 2^{-R_n} * (1 + 1/2 * 2^{-R_n - 1} * (1 + ...1/2 * 2^{-R_2} * (1 + 2^{-R_1})...))$$

$$(2) \qquad G \ = \ - 20 * \log(Y/X)$$

Dabei stellt Y den Dezimalwert des Datenwortes OUT und X den Dezimalwert des Datenwortes IN dar, während $R_1...R_n$ für die jeweilige Anzahl von Rechtsschiebeoperationen steht. G symbolisiert das Dämpfungsmaß, das gleich dem negativen zwanzigfachen Logarithmus des Quotienten Y/X ist. Durch Ausmultiplizieren von Gleichung (1) ergibt sich:

$$(3) \qquad Y/X \ = \ 2^{- R_n - 1} + 2^{- R_n - R_{n-1} - 2} + ... + 2^{- R_n - R_{n-1} - R_2... - (n - 1)} + 2^{- R_n - R_{n-1}... - R_2 - R_1 - (n - 1)}$$

Gleichung (3) liefert den Beweis der Eindeutigkeit zwischen dem erzielten Dämpfungsmaß und dem zugehörigen, die Schiebeoperationen beschreibenden Koeffizientensatz $R_1...R_n$. Außerdem ist daraus ersichtlich, daß der Quotient Y/X bzw. das realisierbare Dämpfungsmaß unabhängig von der Wahl der Indizes n zwischen 1 und 0 bzw. zwischen OdB und +oodB liegt. Wie später noch gezeigt wird, kann ein anderes minimales Dämpfungsmaß als beispielsweise OdB dadurch erzielt werden, indem beispielsweise einer erfindungsgemäßen Schaltungsanordnung eine Schaltungseinheit mit konstanter Verstärkung oder konstanter Dämpfung vor- oder nachgeschaltet wird.

Der Koeffizientensatz $R_1...R_n$ wird aus dem Binärwort A gewonnen. Das Binärwort A ist dazu in n Teilbinärworte aufgeteilt. Dazu wird beispielsweise das zur Aufnahme des Binärwortes A vorgesehene Register MR2 in n Teilregister aufgespalten. Jedes der Teilbinärworte bzw. der Teilregister weist eine bestimmte Breite auf, die untereinander gleich oder verschieden sein kann, jedoch mindestens ein Bit beträgt. Die Gesamtbreite aller Teilbinärworte bzw. Teilregister ergibt die Breite des Teilbinärwortes A bzw. des Registers MR2. Ein Teilbinärwort bzw. der Inhalt eines Teilregisters wird dabei vorzeichenlos als Dezimalzahl interpretiert, d.h. diese Dezimalzahl ist gleich der Stellenzahl, um die rechtsgeschoben wird, also gleich einem der Koeffizienten des Koeffizientensatzes $R_1$ bis $R_n$.

Beim Ausführungsbeispiel nach Figur 1 ist n gleich 4. Die Teilregister MT1 bis MT4 weisen dabei ausgehend vom niederwertigsten Teilregister MT1 eine Breite von 2,1,2 und 4 Bit auf. Ist beispielsweise das Binärwort A gleich 010101011 so ergibt sich für das Teilbinärwort SB1 ein Wert von 11 entsprechend einem Dezimalwert von 3, für das Teilbinärwort SB2 ein Wert von 0 entsprechend einem Dezimalwert von 0, für das Teilbinärwort SB3 ein Wert von 01 entsprechend einem Dezimalwert von 1 und für das Teilbinärwort SB4 ein Wert von 0101 entsprechend einem Dezimalwert von 5. Daraus folgt nun, daß das Schieberegister SR1 das in ihm abgelegte Binärwort um drei Stellen rechtsschiebt. Bei den Schieberegistern SR2, SR3 und SR4 werden die entsprechenden Binärworte demzufolge um eine bzw. zwei bzw. sechs Stellen rechtsgeschoben. Wird nun das Binärwort A geändert, so ergeben sich auch für den Koeffizientensatz $R_1...R_4$ der Schieberegister SR1 bis SR4 andere Werte.

Der Quotient Y/X ist abhängig vom jeweils im Register MR2 abgelegten Binärwort A, wodurch auch das Dämpfungsmaß G der Anordnung vom Binärwort A abhängt und zwar in der Weise, daß G = K * A ist. K sei dabei ein gegebener Proportionalitätsfaktor. Da im vorliegenden Ausführungsbeispiel das Binärwort A bzw. das Register MR2 eine Breite von 9 Bit aufweist, kann das Binärwort A $2^9$-1 verschiedene Werte annehmen entsprechend der gleichen Anzahl unterschiedlicher Dämpfungen. Damit ergibt sich für drei beliebige Werte $A_1$, $A_2$, $A_3$ des Binärwortes A und der daraus resultierenden Dämpfungsmaße $G(A_1)$, $G(A_2)$, $G(A_3)$ allgemein folgender Zusammenhang:

$$(4) \ A_2 = A_1 + 1 \rightarrow G(A_2) > G(A_1)$$

$$A_2 = A_1 - 1 \rightarrow G(A_2) < G(A_1)$$

$$(5) \qquad A_3 \ = \ A_1 + A_2 \rightarrow G(A_3) \approx G(A_1) + G(A_2)$$

$$(6) \qquad A_2 \ = \ A_1/2 \rightarrow G(A_2) \approx G(A_1)/2$$

Die unter (5) und (6) aufgeführten Näherungen gelten jedoch exakt, wenn das Dämpfungsmaß $G(A_1)$ ein Vielfaches (i) von 20*log(2)dB 6dB ist. Daraus ergibt sich:

$$(7) \qquad A_3 \ = \ A_1 + A_2 \leftrightarrow G(A_3) \ = \ G(A_1) + G(A_2) \ \text{mit} \ G(A_1) \ = \ i * 6dB$$

$$(8) \qquad A_2 \ = \ A_1/2 \leftrightarrow G(A_2) \ = \ G(A_1/2) \ \text{mit} \ G(A_1) \ = \ i * 6dB$$

Da bei dem vorgestellten Verfahren im übrigen nur ein angenähert linearer Zusammenhang zwischen Dämpfungsmaß G und Binärwort A besteht, folgt aus der Addition zweier Binärworte $A_1$ und $A_2$, daß die Summe der aus den Binärworten $A_1$ und $A_2$ resultierenden Dämpfungsmaße $G(A_1)$ und $G(A_2)$ nur ungefähr gleich $G(A_1+A_2)$ ist. Analog dazu bewirkt die Halbierung eines beliebigen Binärwortes $A_\mu$, daß das daraus resultie-

3

rende Dämpfungsmaß $G(A_1)$ sich auch nur in etwa halbiert. Um dabei zu erreichen, daß die Summe der Dämpfungsmaße $G(A_1)$ und $G(A_2)$ auf alle Fälle größer oder gleich dem Dämpfungsmaß $G(A_1+A_2)$ ist, wird gemäß Ungleichungen (9) und (10) ein Offsetwert OS, der beim Ausführungsbeispiel gleich -8 ist, zur Summe der Binärworte $A_1$ und $A_2$ hinzuaddiert.

$$(9) \qquad G(A_1) + G(A_2) \geqq G(A_1 + A_2)$$

$$(10) \qquad A_3 = A_1 + A_2 + OS \rightarrow G(A_3) \leqq G(A_1) + G(A_2)$$

Eine Anwendungsmöglichkeit für ein erfindungsgemäßes Verfahren bzw. für eine erfindungsgemäße Schaltungsanordnung besteht bei einer nach einem Waageprinzip arbeitenden Freisprechschaltung. Freisprechschaltungen allgemein ermöglichen ein Telefonieren ohne Handapparat, also über ein freistehendes Mikrofon und einen Lautsprecher. Um eine akustische Kopplung zwischen Lautsprecher und Mikrofon zu verhindern, können Freisprechtelefone daher nur im Wechselsprechbetrieb arbeiten, d.h., es kann immer nur einer der beiden Teilnehmer sprechen, während der andere zuhört. Um dies zu erreichen, benötigt man eine Freisprechschaltung, die feststellt wer gerade spricht, daraufhin den betreffenden Kanal durchschaltet und den anderen genügend abschwächt. Wichtig dabei ist, daß die Schleifenverstärkung unter 1 gehalten wird. Wenn die Sprecher ihre Funktion tauschen, muß die Schaltung dies sofort feststellen und die Kanäle entsprechend umschalten.

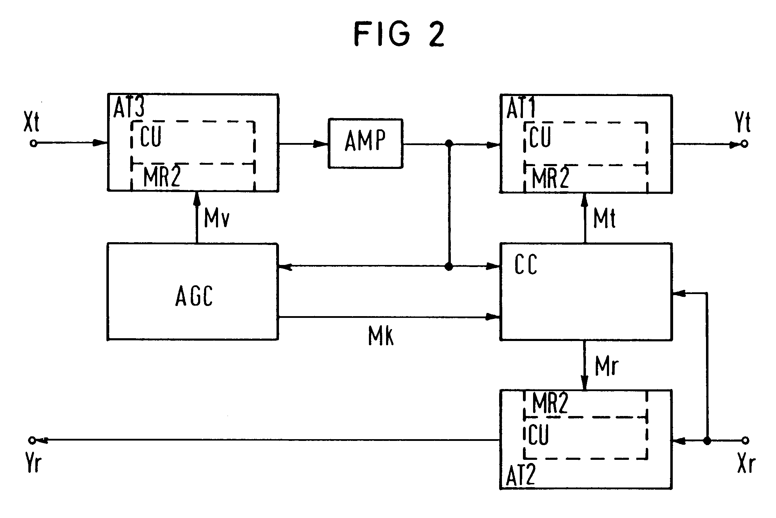

In Figur 2 ist als Anwendungsbeispiel eine digitale Freisprechschaltung dargestellt, die drei Dämpfungsglieder AT1, AT2 und AT3, sowie eine Freisprechsteuereinrichtung CC, eine Verstärkereinheit AMP und eine Verstärkungsregeleinheit AGC aufweist. Das Dämpfungsglied AT1 ist in den Sendeweg geschaltet und wird eingangsseitig mit einem sendeseitigen Eingangssignal Xt, beispielsweise einem digitalisierten Mikrofonsignal, beaufschlagt. Das sendeseitige Eingangssignal Xt wird in Abhängigkeit von einem Steuersignal Mt durch das Dämpfungsglied AT1 gedämpft und als sendeseitiges Ausgangssignal Yt ausgegeben. Entsprechend ist das Dämpfungsglied AT2 in den Empfangsweg geschaltet. Dem Dämpfungsglied AT1 ist die Verstärkereinheit AMP und dieser wiederum das Dämpfungsglied AT3 vorgeschaltet. Das Dämpfungsglied AT3 wird mittels eines Signals Mv gesteuert. Das Signal Mv wird ebenso wie ein Signal Mk von der Verstärkungsregeleinheit AGC erzeugt, die beide Signale Mv und Mk aus dem Ausgangssignal der Verstärkungseinheit AMP gewinnt. Am Eingang des Dämpfungsglieds AT2 liegt ein empfangsseitiges Eingangssignal Xr an, das in Abhängigkeit von einem Steuersignal Mr gedämpft und als sendeseitiges Ausgangssignal Yr ausgegeben wird. Die Steuersignale Mt und Mr werden von der Freisprechsteuereinrichtung CC nach Auswertung von sende- und empfangsseitigem Eingangssignal Xt und Xr sowie dem Signal Mk erzeugt. Die Dämpfungsglieder AT1, AT2 und AT3 bestehen neben einer Steuerlogik jeweils aus einer Recheneinheit und einem Register, die jeweils zu der Recheneinheit CU und dem Register MR2 des Ausführungsbeispieles nach Figur 1 identisch aufgebaut sind. Auf den Registern MR1 und MR3 entsprechende Register wurde dabei verzichtet, da im vorliegenden Anwendungsbeispiel davon ausgegangen wird, daß den Dämpfungsgliedern AT1, AT2 und AT3 vor- bzw. nachgeschaltete Schaltungseinheiten die jeweiligen Binärworte ausreichend lange halten. In diesem Zusammenhang sei darauf hingewiesen, daß auch gegebenenfalls auf das Register MR2 verzichtet werden kann, wenn beispielsweise die Möglichkeit des Speicherns und der Aufteilung in einzelne Teilbinärworte in der Freisprechsteuereinrichtung CC bzw. der Verstärkungsregeleinheit AGC gegeben ist.

Die Freisprechsteuer einrichtung CC steuert durch Ausgabe entsprechender Teilbinärworte Mt und Mr die Dämpfungsglieder AT1 und AT2. Wird in Senderichtung Sprache erkannt, so stellt die Freisprechsteuereinrichtung CC das Dämpfungsglied AT1 auf ein minimales Dämfpungsmaß, bevorzugt OdB, und das Dämpfungsglied AT2 auf ein maximales Dämpfungsmaß. Bei Erkennen von Sprache in Empfangsrichtung wird das Dämpfungsglied AT1 auf maximale und das Dämpfungsglied AT2 auf minimale Dämpfung gestellt. Sobald in Sende- als auch in Empfangsrichtung keine Sprache erkannt wird, werden beide Dämpfungsglieder AT1 und AT2 in einen sogenannten Idle-Zustand gebracht, d.h., bei beiden Dämpfungsgliedern AT1 und AT2 wird ein zwischen minimalem und maximalem Dämpfungsmaß liegender Wert eingestellt. Der Übergang in den Idle-Zustand erfolgt schrittweise durch Anheben der Dämpfung in Senderichtung und Zurücknehmen der Dämpfung in Empfangsrichtung. Der Übergang in den Idle-Zustand erfolgt zudem gehörgerecht annähernd logarithmisch. Wichtig dabei ist wiederum, daß die Schleifenverstärkung in jeder Phase des Übergangs nicht größer als Eins werden darf.

Durch die automatische Regelung der Mikrofonverstärkung sollen Lautstärkerunterschiede, die beispielsweise durch eine sich ändernde Entfernung des Sprechers vom Freisprechmikrofon hervorgerufen werden kann, kompensiert werden. Dazu sind die Verstärkungsregeleinrichtung AGC, das Dämpfungsglied AT3 und die Verstärkereinheit AMP vorgesehen. Das Signal Mv wird durch die Verstärkungsregeleinrichtung AGC so nachgeregelt, daß der Pegel des Ausgangssignals der Verstärkereinheit AMP innerhalb eines gegebenen Beobachtungszeitraums im Mittel annähernd konstant ist. Das sendeseitige Eingangssignal Xt wird dementsprechend mehr oder weniger angehoben. Das resultierende Verstärkungsmaß der Reihenschaltung aus Dämpfungsglied AT3 und Verstärkereinheit AMP ist minimal OdB und maximal beispielsweise 12dB. Dies wird zum Beispiel dadurch erreicht, daß die Verstärkereinheit AMP ein konstantes Verstärkungsmaß von 12dB und das Dämpfungsglied AT3 eine einstellbare Dämpfung von 12dB bis OdB aufweist. Entsprechend dem Ausführungsbeispiel nach FIG 1 gilt:

$$(11) \qquad G(Mv = 64) = 12dB$$

$$(12) \qquad G(Mv = O) = OdB$$

Die Nachregelung des Dämpfungsglieds AT3 erfolgt durch eine oder mehrere aufeinanderfolgende Additions- oder Subtraktionsoperationen auf das Signal Mv. Das Signal Mv nimmt dabei nur Werte im Bereich von 0 bis 64 an. Damit die Schleifenverstärkung nicht größer als Eins wird, muß die Verstärkung das empfangsseitige Eingangssignal Xt bei der Einstellung des Hubs durch die Dämpfungsglieder AT1 und AT2 berücksichtigt werden. Dabei muß folgende Gleichung erfüllt sein:

$$(13) \qquad G(Mr) + G(Mt) = G(MH) - G(Mv) + 12dB$$

Gleichung (13) kann wie folgt umgeformt werden:

$$(14) \qquad G(Mr) + G(Mt) = G(MH')$$

$$(15) \qquad G(MH') = G(MH) + G(Mk)$$

$$(16) \qquad G(Mk) = 12dB - G(Mv)$$

Für den Idle-Zustand gilt:

$$(17) \qquad G(MI) = 1/2\ G(MH')$$

G(Mt), G(Mr) und G(Mv) sind die an den Dämpfungsgliedern AT1, AT2 und AT3 eingestellten, von den jeweiligen Steuersignalen Mt, Mr und Mv abhängigen Dämpfungsmaße. Das von einem Signal MH abhängige Dämpfungsmaß G(MH) beschreibt den durch die Freisprechsteuereinrichtung CC festgelegten Hub zwischen minimaler und maximaler Dämpfung bei den Dämpfungsgliedern AT1 und AT2 für den Fall, daß das Dämpfungsmaß G(Mv) gleich 12dB ist. Der Wert des Signals MH ist dabei als gegeben zu betrachten. Dagegen berücksichtigt das Dämpfungsmaß G(MH') das resultierende Verstärkungsmaß von Dämpfungsglied AT3 und Verstärkereinheit AMP. Es ist daher für die Freisprechsteuereinrichtung CC der maßgebliche Hub. Das Dämpfungsmaß G(MH') ergibt sich aus der Addition von Dämpfungsmaß G(MH) und Dämpfungsmaß G(Mk). Das vom Signal Mk abhängige Dämpfungsmaß G(Mk) entspricht dem negativen Verstärkungsmaß, um das das Dämpfungsmaß G(MH) nachgeregelt werden muß. Im Idle-Zustand sind die Dämpfungsmaße G(Mt) und G(Mr) jeweils gleich der Hälfte des Dämpfungsmaßes G(MH'). Die Steuersignale Mt und Mr sind in diesem Fall gleich dem Wert des Signals MI. Ausgehend von den Gleichungen (14) bis (17) ergibt sich für die entsprechenden Signale MH', MH, MK, MI und Mr:

$$(18) \qquad Mr + Mt + OS = MH'$$

$$(19) \qquad MH' = MH + Mk - OS$$

$$(20) \qquad Mk = 64 - Mv$$

$$(21) \qquad MI = 0,5 * MH'$$

Aus den Signalen MH und Mk berechnet die Freisprechsteuereinrichtung CC die Signale MH' und MI wie folgt: Wird Sprache in Senderichtung erkannt, so setzt sie das Steuersignal Mt gleich O und das Steuersignal Mr gleich dem Signal MH'. Bei Sprache in Empfangsrichtung wird das Steuersignal Mt gleich dem Signal MH' und das Steuersignal Mr gleich O. Sobald weder in Sendenoch in Empfangsrichtung Sprache erkannt wird, werden beide Dämpfungsglieder AT1 und AT2 in den Idle-Zustand gebracht. Dazu wird der Wert des Steuersignals der nicht bedämpften Richtung fortlaufender Addition beispielsweise mit 1 solange erhöht, bis dieser Wert gleich dem Signal MI ist. Der Wert des Steuersignals der anderen Richtung errechnet sich aus Gleichung (18).

Der Offsetwert OS in Gleichung (18) sorgt dafür, daß während des Übergangs in den Idle-Zustand und im Idle-Zustand selbst die Summe der Dämpfungen der beiden Dämpfungsglieder AT1 und AT2 nie kleiner als der geforderte Hub werden kann. Der Offsetwert Os bewirkt gemäß Gleichung (19), daß der vorgegebene Hub mindestens um den Betrag angehoben wird, um den das sendeseitige Eingangssignal Xt durch die Verstärkungsregeleinrichtung AGC angehoben wird.

Mit der in Figur 1 gezeigten Aufteilung des Binärwortes A wird erreicht, daß die Änderung des Dämpfungsmaßes nicht größer als 0.75dB ist, was insbesondere für eine Anwendung im Audiobereich von Vorteil ist, da Dämfpungsänderungen kleiner oder gleich 0.75dB vom menschlichen Gehör nicht wahrgenommen werden. Außerdem besteht ein im wesentlichen linearer Zusammenhang zwischen dem Binärwort A und dem Dämpfungsmaß. Dadurch muß zum gleichzeitigen Erhöhen und Erniedrigen der Dämpfungen bei den beiden Dämpfungsgliedern AT1 und AT2 das jeweilige Steuersignal Mt bzw. Mr nur um einen bestimmten Wert erhöht bzw. erniedrigt werden muß. Dazu sind lediglich einfache Addier- bzw. Subtrahiervorgänge notwendig, die nur einen geringen schaltungstechnischen Aufwand erfordern.

Vorteile der Erfindung sind neben dem geringen schaltungstechnischen Aufwand, der bei einer Realisierung in integrierter Technik einen geringen Flächenbedarf erfordert, vor allem das einfache Einstellen der jeweiligen Dämpfung durch leicht zu realisierende Additions- und Subtraktionsoperationen sowie ein eindeutiger Zusammenhang zwischen dem die Dämpfung bestimmenden Binärwort bzw. Signal und dem zu dämpfenden Binärwort bzw. Signal. Dadurch ist gewährleistet, daß auch nach einer beliebigen Anzahl von Nachregelungen der Zustand der Schaltungsanordnung eindeutig definiert ist.

## Patentansprüche

1. Verfahren zur nichtlinearen Verknüpfung zweier Binärworte (IN, A),
   bei dem in einem ersten Verfahrensschritt das erste Binärwort (IN) um eine dem ersten Verfahrensschritt zugeordnete Stellenzahl rechtsgeschoben und dazu das erste Binärwort (IN) selbst unverändert addiert wird,
   bei dem in n-2 weiteren Verfahrensschritten das Additionsergebnis des vorausgehenden Verfahrensschrittes um eine Stelle sowie um eine dem jeweiligen Verfahrensschritt zugeordnete Stellenzahl rechtsgeschoben und dazu das erste Binärwort (IN) unverändert addiert wird,
   bei dem in einem letzten Verfahrensschritt das Additionsergebnis des vorausgehenden Verfahrensschrittes um eine Stelle sowie um eine dem letzten Verfahrensschritt zugeordnete Stellenzahl rechtsgeschoben wird, und
   bei dem das zweite Binärwort (A) in n Teilbinärworte (SB1, SB2, SB3, SB4) aufgeteilt wird und die den einzelnen Verfahrensschritten zugeordneten Stellenzahlen jeweils einem Teilbinärwort entsprechen.

2. Verfahren nach Anspruch 1,
   **dadurch gekennzeichnet**, daß die Teilbinärworte (SB1, SB2, SB3, SB4) aus mindestens einem Bit des zweiten Binärwortes bestehen,
   daß Teilbinärworte (SB1, SB3, SB4) mit mehr als einem Bit nur nebeneinanderliegende Bits des zweiten Binärwortes (A) aufweisen und
   daß die Teilbinärworte (SB1, SB2, SB3, SB4) mit zunehmender Wertigkeit innerhalb des zweiten Binärwortes (A) den Stellenzahlen in der Reihenfolge der zugehörigen Verfahrensschritte zugeordnet sind.

3. Verfahren nach Anspruch 2,
   **dadurch gekennzeichnet**, daß das Teilbinärwort (SB1) mit niedrigster Wertigkeit innerhalb des zweiten Binärwortes (A) zwei Bit aufweist und daß die Anzahl der Bits bei den übrigen Teilbinärworten (SB2, SB3, SB4) mit steigender Wertigkeit innerhalb des zweiten Binärwortes (A) bei eins beginnend jeweils gleich einer Potenz von zwei ist.

4. Verfahren nach einem der Ansprüche 1 bis 3,
   **dadurch gekennzeichnet**, daß beim ersten Verfahrensschritt das erste Binärwort (IN) um eine weitere Stelle rechtsgeschoben wird.

5. Schaltungsanordnung zur nichtlinearen Verknüpfung zweier Binärworte (IN, A),
   mit einem ersten Register (MR1), in das das erste Binärwort (A) eingelesen wird,
   mit einem aus n Teilregistern (MT1, MT2, MT3, MT4) bestehenden zweiten Register (MR2) in das das zweite Binärwort (A) eingelesen wird, und
   mit einer mit dem ersten Register (MR1) und den n Teilregistern (MT1, MT2, MT3, MT4) verbundenen Recheneinrichtung (CU), die zunächst das erste Binärwort (A) um eine in einem der Teilregister (MT1) abgelegte Stellenzahl rechtsschiebt und dazu das erste Binärwort (IN) addiert, die daraufhin n-2 mal nacheinander das jeweils vorausgehende Additonsergebnis um eine Stelle sowie um eine jeweils in den weiteren Teilregistern (MT2, MT3, MT4) abgelegte Stellenzahl rechtsschiebt und dazu das erste Binärwort (IN) addiert und die schließlich das letzte Additionsergebnis um eine Stelle sowie um eine in dem letzten Teilregister (MT4) abgelegte Stellenzahl rechtsschiebt.

6. Schaltungsanordnung nach Anspruch 5,

**dadurch gekennzeichnet**, daß die Teilregister (MT1, MT2, MT3, MT4) entsprechend ihrer Wertigkeit innerhalb des zweiten Registers (MR2) den einzelnen Schiebeoperationen zugeordnet sind.

7. Schaltungsanordnung nach Anspruch 6,
**dadurch gekennzeichnet**, daß das Teilregister (MT1) mit niedrigster Wertigkeit 2 Bit breit ist und die Breite der übrigen Teilregister (MT2, MT3, MT4) mit steigender Wertigkeit bei eins beginnend gleich Potenzen von zwei beträgt.

8. Schaltungsanordnung nach einem der Ansprüche 5 bis 7,
**dadurch gekennzeichnet**, daß die Recheneinheit (CU) das erste Binärwort (IN) zunächst um eine weitere Stelle rechtsschiebt.

9. Schaltungsanordnung nach einem der Ansprüche 1 bis 6,
**dadurch gekennzeichnet**, daß die Recheneinheit (CU) aus n Schieberegistern (SR1, SR2, SR3, SR4) besteht, die unter Zwischenschaltung von Addierern (AD1, AD2, AD3) in Reihe geschaltet sind, wobei den Addierern (AD1, AD2, AD3) und dem ersten der Schieberegister (SR1) das erste Binärwort (IN) zugeführt wird.

**Claims**

1. Method for the non-linear combination of two binary words (IN, A), in which, in a first method step, the first binary word (IN) is shifted to the right by a number of places assigned to the first method step and to this is added the itself unchanged first binary word (IN), in which, in n-2 further method steps, the addition result of the preceding method step is shifted to the right by one place and by a number of places assigned to the respective method step and to this is added the unchanged first binary word (IN), in which, in a final method step, the addition result of the preceding method step is shifted to the right by one place and by a number of places assigned to the final method step, and in which the second binary word (A) is split into n sub-binary words (SB1, SB2, SB3, SB4) and the numbers of places assigned to the individual method steps in each case correspond to a sub-binary word.

2. Method according to Claim 1, characterized in that the sub-binary words (SB1, SB2, SB3, SB4) comprise at least one bit of the second binary word, in that sub-binary words (SB1, SB3, SB4) with more than one bit have only adjacent bits of the second binary word (A) and in that the sub-binary words (SB1, SB2, SB3, SB4) with increasing significance within the second binary word (A) are assigned to the place numbers in the order of the associated method steps.

3. Method according to Claim 2, characterized in that the sub-binary word (SB1) with least significance within the second binary word (A) has two bits and in that the number of bits in the other sub-binary words (SB2, SB3, SB4) with increasing significance within the second binary word (A), beginning at one, is in each case equal to a power of two.

4. Method according to one of Claims 1 to 3, characterized in that in each method step the first binary word (IN) is shifted to the right by one further place.

5. Circuit for the non-linear combination of two binary words (IN, A), having a first register (MR1), into which the first binary word (A) is read, having a second register (MR2), comprising n subregisters (MT1, MT2, MT3, MT4), into which the second binary word (A) is read, and having a computation unit (CU), connected to the first register (MR1) and to the n subregisters (MT1, MT2, MT3, MT4), which computation unit initially shifts the first binary word (A) to the right by a number of places stored in one of the subregisters (MT1) and adds to this the first binary word (IN), which computation unit thereupon, n-2 times in succession, shifts the respectively preceding addition result to the right by one place and by a number of places stored respectively in the further subregisters (MT2, MT3, MT4) and to this adds the first binary word (IN) and which computation unit finally shifts the final addition result to the right by one place and by a number of places stored in the final subregister (MT4).

6. Circuit according to Claim 5, characterized in that the subregisters (MT1, MT2, MT3, MT4) are assigned to the individual shifting operations in accordance with their significance within the second register (MR2).

7. Circuit according to Claim 6, characterized in that the subregister (MT1) with the least significance is two bits wide and the width of the other subregisters (MT2, MT3, MT4) with increasing significance, beginning at one, is equal to powers of two.

8. Circuit according to one of Claims 5 to 7, characterized in that the computation unit (CU) initially shifts the first binary word (IN) to the right by one further place.

9. Circuit according to one of Claims 1 to 6, characterized in that the computation unit (CU) comprises n shift registers (SR1, SR2, SR3, SR4), which are connected in series with adders (AD1, AD2, AD3) connected in between, the first binary word (IN) being delivered to the adders (AD1, AD2, AD3) and to the first of the shift registers (SR1).

## Revendications

1. Procédé pour la combinaison non linéaire de deux mots binaires (IN, A),
   dans lequel on décale vers la droite, lors d'une première étape opératoire, le premier mot binaire (IN) d'un nombre de places associé à la première étape opératoire et on lui ajoute le même premier mot binaire (IN) inchangé,
   dans lequel on décale vers la droite, lors de n-2 étapes opératoires, le résultat de l'addition de l'étape opératoire précédente, d'une place ainsi que d'un nombre de places associé à l'étape opératoire respective et on lui ajoute le premier mot binaire inchangé (IN),
   dans lequel on décale vers la droite, lors d'une dernière étape opératoire, le résultat de l'addition de l'étape opératoire précédente, d'une place ainsi que d'un nombre de places associé à la dernière étape opératoire, et
   dans lequel on subdivise le deuxième mot binaire (A) en n mots binaires partiels (SB1, SB2, SB3, SB4) et les nombres de places associés aux différentes étapes opératoires correspondent chacun à un mot binaire partiel.

2. Procédé suivant la revendication 1,
   caractérisé en ce que les mots binaires partiels (SB1, SB2, SB3, SB4) sont constitués d'au moins un bit du deuxième mot binaire,
   les mots binaires partiels (SB1, SB3, SB4) ayant plus d'un bit n'ont que des bits voisins l'un de l'autre, du deuxième mot binaire (A) et
   les mots binaires partiels (SB1, SB2, SB3, SB4) de poids croissant dans le deuxième mot binaire (A) sont associés aux nombres de places dans l'ordre des étapes opératoires correspondantes.

3. Procédé suivant la revendication 2,
   caractérisé en ce que le mot binaire partiel (SB1) de plus faible poids dans le deuxième mot binaire (A) a deux bits et le nombre de bits pour les autres mots binaires partiels (SB2, SB3, SB4) de poids croissant dans le deuxième mot binaire (A) commence à un et est égal respectivement à une puissance de deux.

4. Procédé suivant l'une des revendications 1 à 3,
   caractérisé en ce que on décale vers la droite lors de la première étape opératoire, le premier mot binaire (IN), d'une autre place.

5. Montage de combinaison non linéaire de deux mots binaires (IN, A),
   comportant un premier registre (MR1), dans lequel le premier mot binaire (A) est lu,
   comportant un deuxième registre (MR2) constitué de n registres partiels (MT1, MT2, MT3, MT4) dans lequel le deuxième mot binaire (A) est lu, et comportant un dispositif (CU) de calculs, qui est relié au premier registre (MR1) et aux n registres partiels (MT1, MT2, MT3, MT4), qui décale vers la droite d'abord le premier mot binaire (A), d'un nombre de places mémorisé dans l'un des registres partiels (MT1), qui y additionne le premier mot binaire (IN), qui décale ensuite n-2 fois successivement le résultat précédant de l'addition, d'une place ainsi que d'un nombre de places mémorisé dans les autres registres partiels (MT2, MT3, MT4), qui y additionne le premier mot binaire (IN) et qui décale vers la droite enfin le dernier résultat de l'addition, d'une place ainsi que d'un nombre de places mémorisé dans le dernier registre partiel (MT4).

6. Montage suivant la revendication 5,

caractérisé en ce que les registres partiels (MT1, MT2, MT3, MT4) sont associés aux différentes opérations de décalage, suivant leur poids dans le deuxième registre (MR2).

7. Montage suivant la revendication 6,
caractérisé en ce que le registre partiel (MT1) de plus faible poids a une largeur de bit et la largeur des autres registres partiels (MT2, MT3, MT4) de poids croissant commence à un et est égal à une puissance de deux.

8. Montage suivant l'une des revendications 5 à 7,
caractérisé en ce que l'unité (CU) de calcul décale vers la droite le premier mot binaire (IN) d'abord d'une autre place.

9. Montage suivant l'une des revendications 1 à 6,
caractérisé en ce que l'unité (CU) de calcul est constituée de n registres (SR1, SR2, SR3, SR4) à décalage, qui sont branchés en série par insertion d'additionneurs (AD1, AD2, AD3), le premier mot binaire (IN) étant envoyé aux additionneurs (AD1, AD2, AD3) et au premier des registres à décalage (SR1).

# FIG 1

FIG 2